(19)

**Europäisches Patentamt**
**European Patent Office**
**Office européen des brevets**

(11) **EP 4 734 369 A1**

(12) **EUROPEAN PATENT APPLICATION**

(43) Date of publication:
**29.04.2026 Bulletin 2026/18**

(21) Application number: **24208412.7**

(22) Date of filing: **23.10.2024**

(51) International Patent Classification (IPC):
**H03K 17/0412** (2006.01)    **H02M 1/00** (2006.01)
**H02M 1/08** (2006.01)    **H02M 3/158** (2006.01)
**H03K 17/16** (2006.01)

(52) Cooperative Patent Classification (CPC):
**H03K 17/04123; H02M 1/08; H03K 17/164;**
H02M 3/1582; H03K 2217/0081; H03K 2217/009

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB Schweiz AG**
**5400 Baden (CH)**

(72) Inventors:
• **Peltonen, Lauri**
 **00380 Helsinki (FI)**
• **Salmia, Teemu**
 **00380 Helsinki (FI)**

(74) Representative: **Kolster Oy Ab**
**Salmisaarenaukio 1**
**P.O. Box 204**
**00181 Helsinki (FI)**

(54) **CURRENT SOURCE GATE DRIVER**

(57)    A switch-mode current source gate driver comprises separate buck converters (22, 24) for turning on and turning off a power semiconductor switch (IGBT). A constant current ($I_{L1}$, $I_{L2}$) of desired level is kept flowing continuously in a series inductor (L1, L2) of the buck converter, regardless of whether the driven power semiconductor switch is in a turn-on stage or a turn-off stage.

Each buck converter (22, 24) is provided with an auxiliary switch (Q2, Q4) that can be controlled to either allow the continuous inductor current ($I_{L1}$, $I_{L2}$) of the respective buck converter to flow to the gate (G) of the power semiconductor switch (IGBT) or to "shunt" the inductor current to a power supply (Vcc, Vee).

Fig. 2

**EP 4 734 369 A1**

**Description**

FIELD OF THE INVENTION

The invention relates to gate drivers, and more particularly to current source gate drivers for semiconductor power switching devices.

BACKGROUND OF THE INVENTION

MOSFET (Metal Oxide Field Effect Transistor) and IGBT (Insulated Gate Bipolar Transistor) are essential semiconductor switching components used in the design of many circuits ranging from a simple driver circuit to complex power rectifiers and converters. MOSFET is a voltage-controlled device, in which a voltage applied to a gate controls a voltage and a current flow between a source and a drain, the MOSFET will start conducting through the drain and source pins. IGBT is a switching component with two characteristics: high-power as bipolar transistor, high-speed converting and voltage driven as MOSFET. A voltage applied to a gate controls a voltage and a current flow between a collector and an emitter. MOSFET and IGBT have similar input characteristics with some parasitic capacitances, such as a gate capacitance $C_{ge}$ and an input capacitance $C_{iss}$. The input capacitance consists of two nonlinear components that are commonly called the gate capacitance ($C_{ge}$) and the gate-collector (Miller) capacitance ($C_{gc}$). The input capacitance may be defined by the parallel connected gate-emitter capacitance $C_{ge}$ and gate-collector $C_{cg}$ capacitance, $C_{iss} = C_{ge} + C_{cg}$. These capacitances have great effects on the behaviours of the semiconductor switch during a switching period. Gate driver circuits are typically arranged to charge and discharge the gate capacitance $C_{ge}$ (or generally the input capacitance $C_{iss}$) so as to switch on and off the IGBT according to a control or gating signal(s). The control of the gate voltage and gate current is important as it controls the switching behaviour, and thus the losses and electromagnetic emissions, of the power semiconductor switch and the switching apparatus, such as a high-power variable frequency drive.

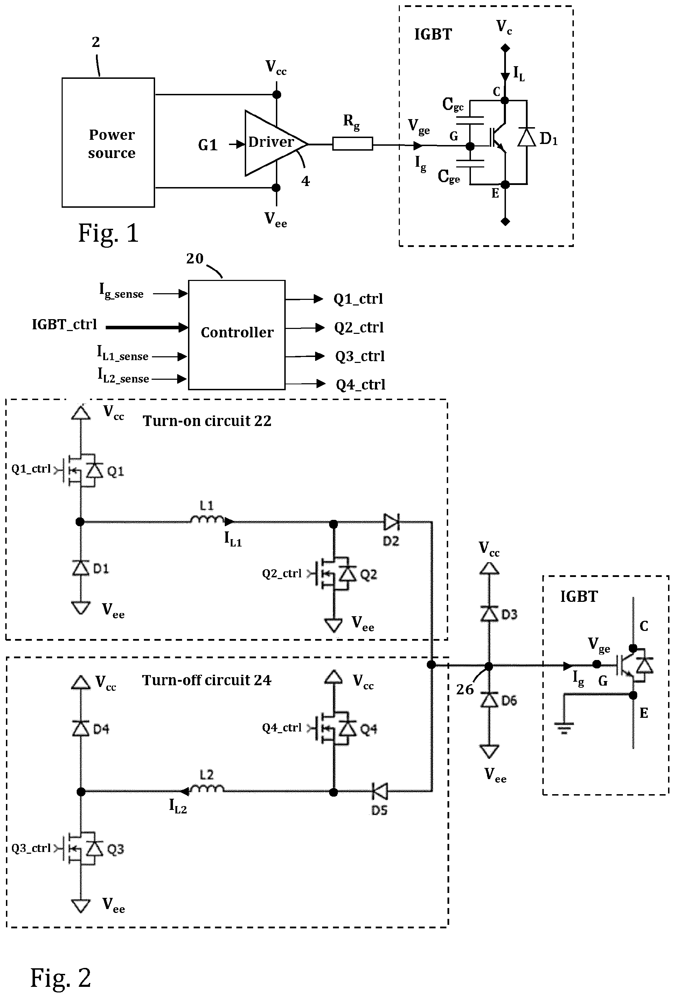

In the most common gate control technology, a drive circuit consists of a linear circuit where resistors are used to limit the gate current of the IGBT or MOSFET, and the switching operation is controlled by selection of the resistors. An example of an IGBT gate driving control 4 having a bipolar voltage source ($V_{cc}$, $V_{ee}$) 2 and an output connected via a gate resistor $R_g$ to a gate G of an IGBT is illustrated in Fig. 1. The bipolar voltage source may be $\pm 15$ V, for example. The IGBT may be provided with an antiparallel diode D1, also called a freewheeling diode or a zero diode. The output of the gate driver 4, and thereby a gate voltage $V_{ge}$ swings from a rail to rail, i.e., from $V_{ee}$ to $V_{cc}$ for turning on of the IGBT, and from $V_{cc}$ to Vee to turning off the IGBT according to the one or more control or gating signals G1. The turn-on and turn-off of the IGBT depend on the gate voltage $V_{ge}$ between the gate G and an emitter E of the IGBT. Voltages Vcc and Vee are often referred as a turn-on voltage and a turn-off voltage, respectively, of the IGBT. In this kind of gate driver, so-called "voltage source" gate driver, the gate power source behaves like a voltage source to charge and discharge the gate of the semiconductor power switching device. The switching speed of modern IGBTs is such that the gate voltage swings from $V_{cc}$ to $V_{ee}$ or vice versa in roughly a microsecond; more or less depending on the IGBT and its driver circuit.

IGBT is basically a charge-controlled device, which means that the switching operation depends on how the charge from the gate capacitance is removed. The switching transition of the IGBT is described e.g. in the article A Novel Active Gate Drive for HV-IGBTs Using Feed-forward Gate Charge Control Strategy, Fan Zhang et al., IEEE 2015. The turn-off collector voltage rising rate value for the turn-off switching voltage transition can be expressed as

$$\frac{dV_{ce(off)}}{dt} = \frac{V_{ee} - V_{ge(th)} - I_L/g_m}{R_g \cdot C_{gc}} \qquad (1)$$

where $V_{ee}$ is the turn-off voltage of the gate driver, $R_g$ the gate driver resistor, $V_{ge(th)}$ is the threshold voltage of the IGBT, $I_L$ the load current, $g_m$ is the transconductance of the IGBT, and $C_{gc}$ is the gate-collector capacitance of the IGBT.

Similarly, the turn-off collector current rising rate value for the turn-off switching current transition can be expressed as

$$\frac{dI_{c(off)}}{dt} = -\frac{V_{ee} - V_{ge(th)} - I_L/g_m}{L_{E1} + R_g \cdot C_{iss}/g_m} \qquad (2)$$

where $L_{E1}$ is the parasitic inductance of the emitter current path, which in some cases can be neglected if an auxiliary emitter for the gate driver is provided by the IGBT package, as is the case for high power IGBTs.

Similar analysis for the benefit of current source gate driver using current as the driver instead of voltage and gate resistance can be found e.g. in the article Current Source Gate Drivers Boost the Turn-On Performance of IGBT, Wolf-gang Frank et al., Infineon Technologies AG, November 2018.

From the equations (1) and (2) one can see that 1) the IGBT switching behaviour depends on the load current $I_L$ and the IGBT's transconductance $g_m$ in addition to the gate voltage $V_{ge}$ and the IGBT threshold voltage $V_{ge(th)}$. This means that for a given gate voltage $V_{ge}$ and gate resistance $R_g$, the switching performance is different depending on the load current $I_L$, and that 2) the gate voltage divided by the gate resistance equals the gate current $I_g$, which means that in effect the switching performance is dependent on the gate current $I_g$ itself.

With a conventional resistor-based gate driver as well as with a linear constant current gate driver, a similar amount of energy is dissipated as heat in the gate driver circuit as is transferred to the gate in every switching. This means that for high switching frequency, the power loss becomes high and the circuit size and cost increases. An example of a linear constant current gate driver where a MOSFET is used as a "variable resistor" to achieve a constant current is disclosed in the datasheet EiceDRIVER™ 1EDS-SRC family Slew rate control IGBT driver IC, Infineon Technologies AG, January 2020.

Furthermore, many current source gate drivers provide active control of the gate to control the switching behaviour as well as the power transistor losses. In these circuits the driver power losses are similar to that of a gate resistor-based driver, and the complexity and price of the gate driver are very high. An example of an active current source gate driver is disclosed in the article Active Current Source IGBT Gate Drive with Closed-Loop di/dt and dv/dt Control, Lu Shu et al., IEEE Transactions On Power Electronics, vol. 32, no. 5, May 2017.

Low-loss (or "lossless") gate drivers have been proposed which often are of resonant type, where an inductor is used instead of gate resistors, and together with the gate capacitance form a resonant circuit. See e.g. the article A New Lossless Power Mosfet Driver Based on Simple DC/DC Converters, J. Diaz et. al., IEEE 1995. These types of gate drivers can provide low-loss operation, but the driving current is far from constant as it is more of a sinusoidal form.

With a switch mode power supply, the constant current driver efficiency could be improved. However, in order to keep the current regulated while the gate voltage rapidly changes, the control loop bandwidth must be very high, and similarly the switching frequency must be very high, in the range of several MHz or more. This is because the IGBT switching instant typically lasts only a fraction of a microsecond.

In the article Current Source Gate Drive Circuits with Low Power Consumption for High Frequency Power Converters, Ayato Sagehashi et al., 9th International Conference on Power Electronics-ECCE Asia, June 2015, a discontinuous current gate driver has been proposed. However, this design has a downside that the gate current must always be ramped up before the switching transient as there is no way to regulate the current. As a result, the switching delay caused by the gate driver increases. Additionally, the operation is not constant current but rather "resonant", providing a near-sinusoidal current to the gate.

Sagehashi et al disclose also a continuous current gate driver but in that the implementation of the current source itself is not presented. Similar issues as described above are present in typical current sources in the presented configuration. In addition, a H-bridge is required for driving the gate, and the on and off state behaviour of the presented circuit is unclear, as the free-wheeling current path is provided by the same H-bridge that is used to drive the gate.

BRIEF DESCRIPTION OF THE INVENTION

An object of the present invention is to provide a constant current gate driver that mitigates or overcomes the at least part of the abovementioned issues. The object of the invention is achieved by a gate driver circuit and a switching apparatus according to the independent claim. The preferred embodiments of the invention are disclosed in the dependent claims.

An aspect of the invention is a switch-mode current source gate driver comprising:

a dc voltage bus having a positive rail and a negative rail couplable to a dc power supply,
a driver output couplable to drive a gate of a power semiconductor switching device,
a turn-on dc-dc converter circuit having a first series inductor acting as a current source for producing a turn-on current to the gate of the power semi-conductor switching device, the turn-on dc-dc converter circuit being configured to keep a turn-on current of a desired level flowing continuously in the first series inductor regardless of whether the driven power semiconductor switching device is in a turn-on stage or a turn-off stage, the turn-on dc-dc converter circuit having a first mode of operation in which the continuous turn-on current is caused to flow to the gate of the power semiconductor switching device in the turn-on stage, and a second mode of operation in which the continuous turn-on current is shunted to the power supply in the turn-off stage,
a turn-off dc-dc converter circuit having a second series inductor acting as a current source for producing a turn-off current to the gate of the power semi-conductor switching device, the turn-off dc-dc converter circuit being configured to keep a turn-off current of a desired level flowing continuously in the second inductance regardless of whether the driven power semiconductor switching device is in the turn-on stage or the turn-off stage, the turn-off dc-dc converter circuit having a first mode of operation in which the continuous turn-off current is caused to flow to the gate of the power semiconductor switching device in the turn-off stage, and a second mode of operation in which the continuous turn-off current is shunted to the power supply in the turn-on stage, and

a controller configured to control the modes of operation of the turn-on dc-dc converter circuit and the turn-off dc-dc converter circuit, wherein the controller is configured to control the turn-on dc-dc converter circuit into the first mode and the turn-off dc-dc converter circuit into the second mode to drive the power semiconductor switching device into the turn-on stage, and wherein the controller is configured to control the turn-on dc-dc converter circuit into the second mode and the turn-off dc-dc converter circuit into the first mode to drive the power semiconductor switching device into the turn-off stage.

In an embodiment, the controller comprises a first current-mode controller to adjust the turn-on current and a second current-mode controller to adjust the turn-off current, the current-mode controllers preferably being peak current controllers.

In an embodiment, the turn-on dc-dc converter circuit is configured to temporarily shunt the turn-on current to the power supply during the turn-on stage of the semiconductor power switching device to boost the continuous turn-on current flowing in the first series inductor, and the turn-off dc-dc converter circuit is configured to temporarily shunt the turn-off current to the power supply during the turn-off stage of the semiconductor power switching device to boost the continuous turn-off current flowing in the second series inductor.

In an embodiment, the controller is configured to sense the turn-on current and the turn-off current and selectively boost the currents so that the turn-on current and the turn-off current have at least a predetermined levels or are within predetermined ranges.

In an embodiment, the turn-on dc-dc converter circuit comprises a first controllable main switch to control the level of the continuous turn-on current in the first series inductor, and a first controllable auxiliary switch to either cause the continuous turn-on current from the first series inductor to the gate of the semi-conductor power switch or to shunt the continuous turn-on current from the first series inductor to the power supply, and wherein the turn-off dc-dc converter circuit comprises a first controllable main switch to control the level of the continuous turn-off current in the second series inductor, and a second controllable auxiliary switch to either cause the continuous turn-off current from the second series inductor to the gate of the semiconductor power switch or to shunt the continuous turn-off current from the second series inductor to the power supply.

In an embodiment, the first controlled main switch is operationally connected between the positive rail and a first terminal of the first series inductor and the first controlled auxiliary switch is operationally connected between a second terminal of the first series inductor and the negative rail, and wherein the second controlled main switch is operationally connected between the negative rail and a first terminal of the second series inductor and the second controlled auxiliary switch is operationally connected between a second terminal of the second series inductor and the positive rail.

In an embodiment, the turn-on dc-dc converter circuit comprises a first freewheeling semiconductor device operationally connected between the first terminal of the first series inductor and the negative rail, and a second blocking semi-conductor device operationally connected between the second terminal of the first series inductor and the driver output, and wherein the turn-off dc-dc converter circuit comprises a third freewheeling semiconductor device operationally connected between the first terminal of the second series inductor and the positive rail, and a fourth blocking semi-conductor device operationally connected between the second terminal of the second series inductor and the driver output.

In an embodiment, the switch-mode current source gate driver comprises a first clamping diode operationally connected between the driver output and the positive rail, and a second clamping diode operationally connected between the driver output and the negative rail.

In an embodiment, the two or more switch-mode current source drivers are connected in parallel to drive one semi-conductor power switching device, wherein the parallel gate driver stages can be selectively enabled and disabled to boost a gate current during a gate voltage transition.

In an embodiment, the parallel gate driver stages are selectively enabled and disabled by selectively turning on and off the auxiliary switches of the gate driver stages.

In an embodiment, the selective enabling and disabling of the parallel gate driver stages is time-based.

In an embodiment, the selective enabling and disabling of the parallel gate driver stages is based on the level of the gate voltage.

In an embodiment,

the turn-on dc-dc converter circuits of all gate driver stages are enabled for a certain period of time after start of a turn-on event,
the turn-on dc-dc converter circuits of all but one of the gate driver stages are disabled after said certain period or periods of time,
the turn-off dc-dc converter circuits of all gate driver stages are enabled for a certain period of time after start of a turn-off event, and
the turn-off dc-dc converter circuits of all but one of the gate driver stages are disabled after said certain period or periods of time.

In an embodiment,

the turn-on dc-dc converter circuits of all gate driver stages are enabled, when the gate voltage is below a positive boost threshold during a turn-on event,
the turn-on dc-dc converter circuits of all but one of the gate driver stages are disabled, when the gate voltage exceeds the positive boost threshold during the turn-on event,
the turn-off dc-dc converter circuits of all gate driver stages are enabled, when the gate voltage is higher than a turn-off boost threshold during a turn-off event,
the turn-off dc-dc converter circuits of all but one of the gate driver stages are disabled, when the gate voltage is lower than the turn-off boost threshold during the turn-off event.

In an embodiment,

the turn-on dc-dc converter circuit of one or more disabled gate driver stages enabled again to boost the final part of the IGBT turn-on after the gate voltage exceeds a predefined positive higher level, and
the turn-off dc-dc converter circuit of one or more disabled gate driver stages enabled again to boost the final part of the IGBT turn-off after the negative-going gate voltage is lower than a predefined lower voltage level.

Another aspect of the invention is a switching apparatus, particularly a power converter, an inverter, or a rectifier, comprising

two or more semiconductor power switching devices,
the switch-mode current source gate driver according to embodiments of the first aspect for each of the two or more semiconductor power switching devices.

BRIEF DESCRIPTION OF THE DRAWINGS

In the following the invention will be described in greater detail by means of exemplary embodiments with reference to the accompanying drawings, in which

Figure 1 shows a simplified circuit diagram illustrating a conventional gate driver circuit;
Figure 2 shows a simplified circuit diagram illustrating an exemplary switch-mode current source gate driver circuit according to embodiments of the invention;
Figures 3, 4, 5, 6, 7, and 8 illustrate exemplary current flows in the turn-on and turn-off converter circuits of Fig. 2 in the turn-off stage, in a turn-off boosting stage, during a transition to from the turn-off stage to the turn-on stage, in the turn-on stage, in a turn-on boosting stage, and during the transition from the turn-on stage to the turn-off stage, respectively;
Figure 9 shows a simplified block diagram illustrating an exemplary control logic for controlling the main switch and the auxiliary switch of the turn-on converter circuit;
Figures 10 and 11 show simulation graphs illustrating the IGBT gate voltage and the gate current during turn-on and turn-off voltage transitions, respectively;
Figure 12 shows simulation graphs illustrating the inductor current and switch control signals of the main and auxiliary switches for the turn-on circuit; and
Figure 13 is a simplified block diagram illustrating a 2-stage gate driver with two current source gate drivers connected parallel.

DETAILED DESCRIPTION

The present invention relates generally to gate driver circuits and control methods for semiconductor power switching devices, such as MOSFET (Metal Oxide Field Effect Transistor) and IGBT (Insulated Gate Bipolar Transistor).
According to an aspect of the invention, a switch-mode current source gate driver is provided with dc-dc-converter circuits for turning on and turning off a power semiconductor switching device. In embodiments, the turn-on and turn-off dc-dc converter circuits both are step-down (buck) converter circuits. Each dc-dc converter circuit is configured in such a way that in a series inductance of the dc-dc converter circuit, a constant current of desired level is kept flowing continuously, regardless of whether the driven power semiconductor switching device is in a turn-on stage or a turn-off stage. Therefore, each dc-dc converter circuit is provided with an auxiliary switch that can be controlled to either allow the continuous inductor current of the respective circuit to flow to the gate of the power semiconductor switching device or to "shunt" the inductor current of the respective circuit to a power supply. For turning-on the power semiconductor switching device, the auxiliary switch of the turn-on dc-dc converter circuit is controlled to route the continuous inductor current of the turn-on buck converter to flow to the driver output and thereby to the gate of the power semiconductor switching device, while the auxiliary switch of the turn-off dc-dc converter is controlled to "shunt" the continuous inductor current of the turn-off dc-dc converter back to the power supply. For turning-off the power semiconductor switching device, the auxiliary switch of the turn-off dc-dc converter circuit is controlled to route the continuous inductor current of the turn-off buck converter to flow to the driver output and thereby to the gate of the power semiconductor switching device, while the auxiliary switch of the turn-on dc-dc converter is controlled to "shunt" the continuous inductor current of the turn-on dc-dc converter back to the power supply. Having separate turn-on and turn-off converter circuits with continuous inductor currents allows rapid transitions from a turned-off stage of the power semiconductor switching device to a turned-on stage and vice versa, without the need to first ramp up the driver's current.. In addition, turn-on and turn-off current levels (i.e., the inductor current levels) can be individually selected. A current mode control offers a better control of the switching behaviour of the power semiconductor; with current mode control the switching performance may be more constant independent of output current level, gate driver voltage level variation, and other parameters.

In embodiments, the inductance of the inductor is selected in such a way that the energy stored in the inductor is significantly higher than the energy transferred to the gate of the power semiconductor switching device. As a result, when the energy stored in the inductor is higher than the transferred energy (i.e., the energy used to toggle the IGBT gate from low to high or vice versa), the current level does not change much during the IGBT transition. This makes the control loop simpler and lower bandwidth can be used as the (IGBT) gate voltage is not part of the control loop. In addition, the switching frequency in the dc/dc converters can be low which lowers the losses in the converters.

In embodiments, the auxiliary switch of the turn-on converter circuit is temporarily turned on for short periods of time during the turn-on stage of the power semiconductor device, and the auxiliary switch of the turn-off converter circuit is temporarily turned on for short periods of time during the turn-off stage of the power semiconductor device, to provide a boost current in the inductor. It is typical for a buck converter that it cannot sustain the inductor current when the gate voltage of the power semiconductor switching device is at the supply (rail) voltage, and the inductor current will slowly decay to zero. With the boosting operation using the auxiliary switch, the inductor current can be kept at a certain level even though the gate voltage of the power semiconductor switching device is at the supply (rail) voltage (i.e., the positive supply voltage in the turn-on stage, and the negative supply voltage in the turn-off stage). This boosted inductor current ensures that the gate voltage of the power semiconductor switching device does not slowly decay but rather stays at the supply voltage level constantly.

In embodiments, the temporary turn-on of the auxiliary switch for boosting operation is controlled for predetermined periods of time at predetermined time intervals.

In embodiments, the temporary turn-on of the auxiliary switch for boosting operation is controlled based on a sensed inductor current and a boosting current threshold. The boosting current threshold may have hysteresis.

Fig. 2 shows a simplified circuit diagram illustrating an exemplary switch-mode current source gate driver circuit according to embodiments of the invention. In exemplary embodiments disclosed herein, the driven semiconductor power switching device is IGBT (Insulated Gate Bipolar Transistor), but it may as well be MOSFET (Metal Oxide Field Effect Transistor). The IGBT may be provided with an antiparallel diode D1, also called a freewheeling diode or zero diode.

The power supply of the gate driver circuit is not illustrated herein, but the positive and negative supply voltages (rails) are only shown as labels. $V_{cc}$ indicates connection to the positive gate drive supply voltage (rail) and $V_{ee}$ indicates connection to negative supply voltage (rail). In the example, the (auxiliary) emitter E of the IGBT is referenced as ground. The power supply (not shown) may include (large) capacitors connected between the positive supply voltage ($V_{cc}$) and IGBT's emitter E (ground), and the negative supply voltage ($V_{ee}$) and the ground. The positive supply voltage $V_{cc}$ may be +15 V, and the negative supply voltage $V_{ee}$ may be - 15 V, for example.

The exemplary gate driver circuit is provided with separate dc-dc converter circuits 22 and 24 for turn-on and turn-off, respectively, of the IGBT. The turn-on circuit 22 may include a dc-dc converter, which is a buck or step-down converter herein, implemented with semiconductor switches Q1 and Q2 (e.g., field effect transistors, FETs), diodes D1 and D2 and a series inductor L1. The transistor Q1 is operationally connected between a positive supply voltage $V_{cc}$ and a first terminal of the inductor L1. The diode D1 is a freewheeling diode operationally connected between the first terminal of the inductor L1 and the negative supply voltage $V_{ee}$. The auxiliary transistor Q2 is operationally connected between a second terminal of the inductor L1 and the negative supply voltage $V_{ee}$. The diode D2 is a blocking diode operationally connected between the second terminal of the inductor L1 and the output 26 of the gate driver circuit. Diode D2 is used to block a current from flowing between the turn-on and turn-off circuitry. Diode D2 also blocks the IGBT gate from discharging through Q2 whenever Q2 is on. The driver output 26 is to be coupled to the gate G of the IGBT.

The turn-off circuit 24 is similar in construction and is implemented with semiconductor switches Q3 and Q4 (e.g., field effect transistors, FETs), diodes D4 and D5 and a series inductor L2. The transistor Q3 is operationally connected between the negative supply voltage $V_{ee}$ and a first terminal of the inductor L2. The diode D4 is a freewheeling diode operationally connected between the first terminal of the inductor L2 and the positive supply voltage $V_{cc}$. The auxiliary transistor Q4 is operationally connected between a second terminal of the inductor L2 and the positive supply voltage $V_{cc}$. The diode D5 is a blocking diode operationally connected between the second terminal of the inductor L2 and the output 26 of the gate driver circuit.

In embodiments, clamping diodes D3 and D6 may be arranged to provide a voltage clamping of the IGBT's gate G so as to prevent the gate voltage $V_{ge}$ from exceeding the supply voltages $V_{cc}$, Vee by more than the voltage drop of the clamping diodes. In embodiments, the clamping diodes D3 and D6 may be omitted, as the antiparallel diodes of transistors Q2 and Q4, through diodes D2 and D5, may provide the same functionality.

The inductor L1 and L2 are designed such that the energy stored in each inductor is significantly higher than the energy transferred to the gate G of the IGBT. In embodiments, the energy stored in each inductor is at least two times, preferably at least four times the energy transferred to the gate G of the IGBT. For example, if the gate charge of the IGBT (from -15 V to +15V) is 750 nC, the energy transferred is E = 0.5*Q*V = 0.5*750nC*30 V = 11.25 $\mu$J. Let us assume that in this example, a gate current of 300 mA is used, and the energy stored in the inductor L1 or L2 is selected to be five times the gate energy. In this case the inductance needs to be at least L = 5*2*E/(I$^2$) = 5*2*11.25 $\mu$J/(0.3 A)$^2$ = 1.25 mH.

The switches Q1, Q2, Q3 and Q4 are controlled turn on and off by switching control signals or gating signals Q1_ctrl, Q2_ctrl, Q3_ctrl, and Q4_ctrl, respectively, applied to their gates from a gate driver control. The control signals or gating signals Q1_ctrl, Q2_ctrl, Q3_ctrl, and Q4_ctrl may preferably be pulse width modulated (PWM) signals. Controller 20 illustrated in Fig. 2 refers generally to any control functions, logic, hardware, firmware, software, etc. required to control the switching of the semiconductor switches in the gate driver circuit. In embodiments, at least lower levels of the gate driver control may be implemented by a programmable logic, such as Field Programmable Gate Arrays (FPGAs). The gate driver control, e.g. the controller 20, may receive an IGBT gating signal IGBT_ctrl that dictates whether the is turned on or off. The IGBT gating signal IGBT_ctrl may preferably be a IGBT PWM signal. The gate driver control, e.g. the controller 20, may further receive sensor signals, e.g. a gate current sensing signal $I_{g\_sense}$ representing the actual level of the gate current $I_g$, gate voltage sensing signal (not shown) representing the actual level of the gate voltage $V_{ge}$, and/or inductor current sensing signals $I_{L1\_Sense}$ and $IL_{2\_sense}$ representing the actual level of the inductor currents $I_{L1}$ and $I_{L2}$.

In embodiments, the main switches Q1 and Q3 can be controlled on and off by means of current-mode controllers so that the inductor currents $I_{L1}$ and $I_{L2}$ are kept at a desired level. Any standard current-mode controller may be used, for example a peak current controller or an average current controller. In embodiments, the switching frequency of the main switches Q1 and Q3 in the current-mode control can be relatively low, e.g. in the range of tens of kHz, depending on the selection of the inductance value of the inductors L1 and L2.

Inductor currents of desired level are kept flowing continuously in the inductors L1 and L2 of the turn-on and turn-off converter circuit 22 and 22, regard-

**Table 1: Control logic for Q2 and Q4**

| IGBT control | Q2 | Q4 |
|---|---|---|
| Turn-on | OFF | ON |
| Turn-off | ON | OFF |

less of whether the IGBT is in a turn-on stage or a turn-off stage. The IGBT is controlled alternatively to the turn-on stage and the turn-off stage based on the IGBT control signal IGBT_ctrl. In the turn-off stage, the auxiliary switch Q4 of the turn-off converter 24 is turned off and the auxiliary switch Q2 of the turn-on converter 22 is turned on. In the turn-on stage, the auxiliary switch Q4 of the turn-off converter 22 is turned on and the auxiliary switch Q4 of the turn-on converter 24 is turned off. The control logic of the auxiliary switches is shown in Table 1.

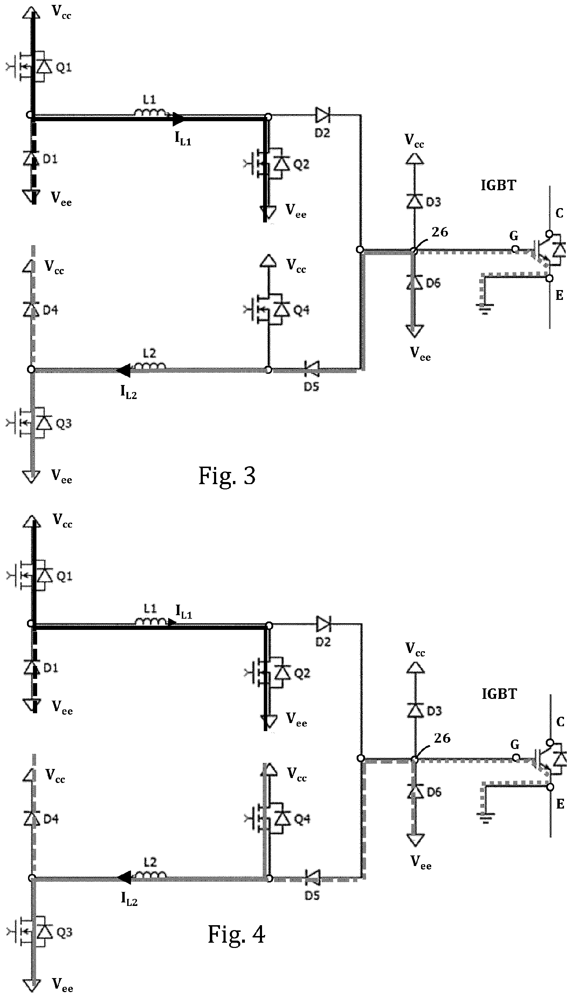

Figs. 3, 4, 5, 6, 7, and 8 illustrate exemplary current flows in the turn-on and turn-off converter circuits 22 and 24 in the turn-off stage, in a turn-off boosting stage, during a transition to from the turn-off stage to the turn-on stage, in the turn-on stage, in a turn-on boosting stage, and during the transition from the turn-on stage to the turn-off stage, respectively. The black solid line is the inductor current $I_{L1}$ (the turn-on current), the grey solid line is the inductor current $I_{L2}$ (the turn-off current), and the dashed lines illustrate freewheeling currents (e.g. when a switching transistor is turned off). The dotted line illustrates an auxiliary current path which is explained separately in each stage.

Referring to Fig. 3, in the turn-off stage, the auxiliary switch Q4 of the turn-off converter 24 is turned off and the auxiliary switch Q2 of the turn-on converter 22 is turned on. The turn-on inductor current $I_{L1}$ of the turn-on circuit 22 is shunted through the auxiliary switch Q2 to the power supply, while the turn-off inductor current $I_{L2}$ of the turn-off circuit 24 is allowed to flow through the diode D5 to the gate G of the IGBT, as illustrated in Fig. 4. The gate voltage $V_{ge}$ is at the turn-off level $V_{ee}$. The turn-off inductor current $I_{L2}$ flows mainly through the clamping diode D6 to the negative supply voltage, but if the IGBT gate voltage $V_{ge}$ tends to rise, a current flows through the gate G to the emitter E and keeps the gate voltage $V_{ge}$ at the turn-off level, as illustrated by the dotted grey line.

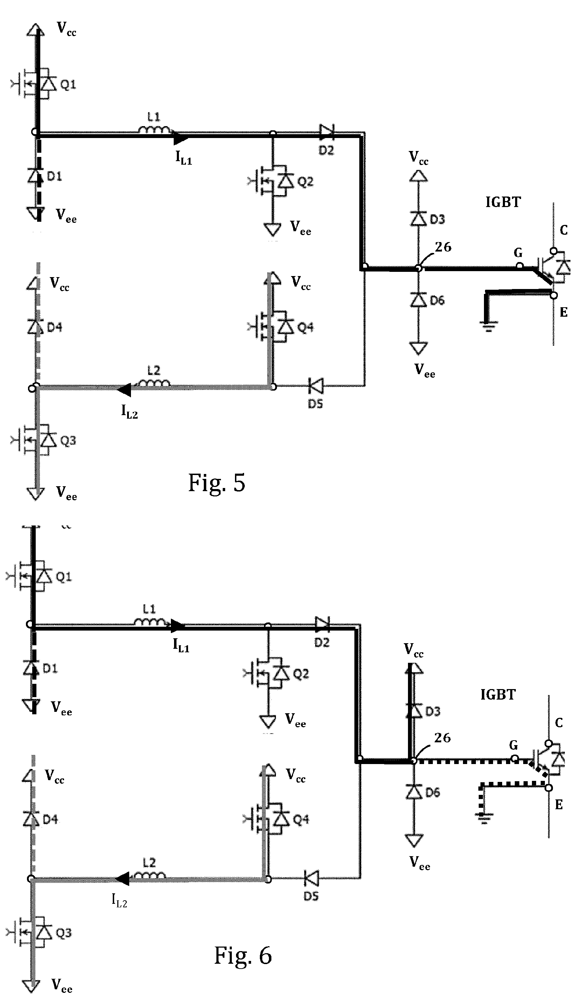

Referring to Fig. 5, the transition from the off-stage to the on-stage of the IGBT is carried out by turning on the auxiliary switch Q4 of the turn-off converter circuit 24 so that the turn-off inductor current $I_{L2}$ is shunted to the power supply through the auxiliary switch Q4. The auxiliary switch Q2 of the turn-on converter circuit 22 is turned off to allow the turn-on inductor current $I_{L1}$ to flow through the diode D2 to the gate G of the IGBT for charging the gate capacitance $C_{ge}$ and raising the gate voltage $V_{ge}$. Finally, referring to Fig. 6, the IGBT reaches the turn-on stage where the gate voltage is at the turn-on level and the turn-on inductor current $I_{L1}$ flows mainly through the clamping diode D3 to the power supply. If the IGBT gate voltage $V_{ge}$ tends to fall, a portion of the current flows through the gate G to the emitter E and keeps the gate voltage $V_{ge}$ high at the turn-on level, as illustrated by the dotted black line.

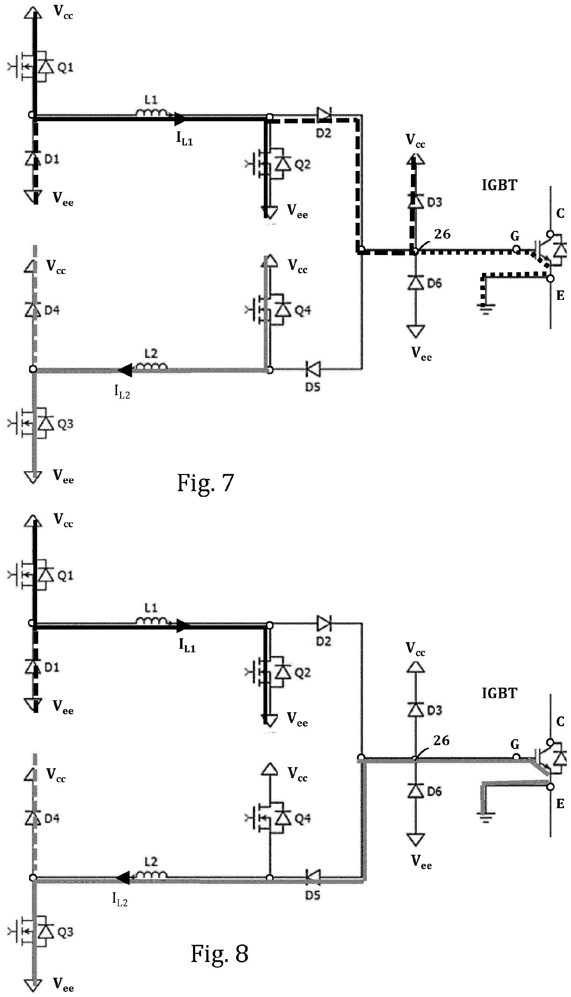

Referring to Fig. 8, the transition from the on-stage to the off-stage of the IGBT is carried out by turning on the auxiliary switch Q2 of the turn-on converter circuit 22 so that the turn-on inductor current $I_{L1}$ is shunted to the power supply through the auxiliary switch Q2. The auxiliary switch Q4 of the turn-off converter circuit 24 is turned off to allow the turn-off inductor current $I_{L2}$ to flow through the diode D5 to the gate G of the IGBT for lowering the gate voltage $V_{ge}$. Finally, the IGBT reaches the turn-off stage illustrated in Fig. 3.

The current control of the main switch Q3 can keep the inductor current $I_{L2}$ at the desired level in the turn-off converter 24 during the turn-on stage of the IGBT. However, since the buck, or step-down, type converter topology presented here may not be able sustain the inductor current $I_{L2}$ in the turn-off stage of the IGBT when the gate voltage $V_{ge}$ is at the negative rail. In other words, when the auxiliary switch Q4 is off and IGBT gate voltage $V_{ge}$ is at the negative supply voltage, the main switch Q3 cannot increase the inductor current $I_{L2}$, and the current will slowly decay to zero. Therefore, in embodiments, the auxiliary switch Q4 may be temporarily turned on for short periods of time during the turn-off stage of the IGBT to keep the current in the inductor L1 flowing. These short turn-on periods of the auxiliary switch Q4 are referred to as turned-off boosting stage herein. The turned-off boosting stage is illustrated in Fig. 4. The auxiliary switch Q4 is turned on and the current $I_{L2}$ is shunted to the positive rail $V_{cc}$. A freewheeling current flows either to the gate G of the IGBT or through the clamping diode D6 to the negative rail.

Similarly, in the turn-on stage of the IGBT, the auxiliary switch Q2 may be temporarily turned on for short periods of time during the turn-off stage of the IGBT to keep the current in the inductor L1 flowing. These short turn-on periods of the auxiliary switch Q2 are referred to as turned-on boosting stage herein. The turned-on boosting stage is illustrated in Fig. 7. The auxiliary switch Q2 is turned on and the current $I_{L1}$ is shunted to the negative rail $V_{ee}$. A freewheeling current flows either to the gate G of the IGBT or through the clamping diode D3 to the positive rail.

The temporary turn-on of the auxiliary switches Q2 and Q4 may be implemented in various ways. In exemplary embodiments, the temporary turn-on of the auxiliary switches Q2 and Q4 for boosting operation is controlled based on sensed inductor currents $I_{L1\_sense}$ and $I_{L2\_sense}$ and boosting current threshold(s). If the sensed inductor current $I_{L1\_sense}$ and $I_{L2\_sense}$ drops below a predetermined limit, the corresponding auxiliary switch Q2 or Q4 is turned on and the inductor current $I_{L1}$ or $I_{L2}$ is boosted until the inductor current has increased enough. This current

Table 2. Control logic for Q2 with boosting behaviour

| IGBT control | IL1 < Ibst,low | IL1 > Ibst,high |
|---|---|---|
| Turn-on | ON | OFF |
| Turn-off | ON | ON |

ensures that the IGBT's gate voltage $V_{ge}$ does not slowly decay but rather stays at the supply voltage level constantly. In embodiments, the auxiliary switch Q2 or Q4 may be turned on for a preset period of time, if the sensed inductor current $I_{L1\_sense}$ or $I_{L2\_sense}$ drops below a predetermined limit. In embodiments, a predetermined current limit with hysteresis may be employed. For example, a boosting control of the auxiliary switch Q2 may be configured as shown in table 2.

In the table, $I_{bst,low}$ is the low threshold level of boosting current and $I_{bst,high}$ is the high threshold level for boosting current. During turn-on stage of the IGBT, the auxiliary switch Q2 is normally off, it the inductor current $I_{L1}$ is sufficiently high. The auxiliary switch Q2 is turned on to boost the inductor current, when the inductor current $I_{L1}$ drops below the low threshold $I_{bst,low}$ level. Q2 is turned off again, when the boosting operation has raised the inductor current $I_{L1}$ above the high threshold $I_{bst,high}$. The boosting control of the auxiliary switch Q4 can be similar.

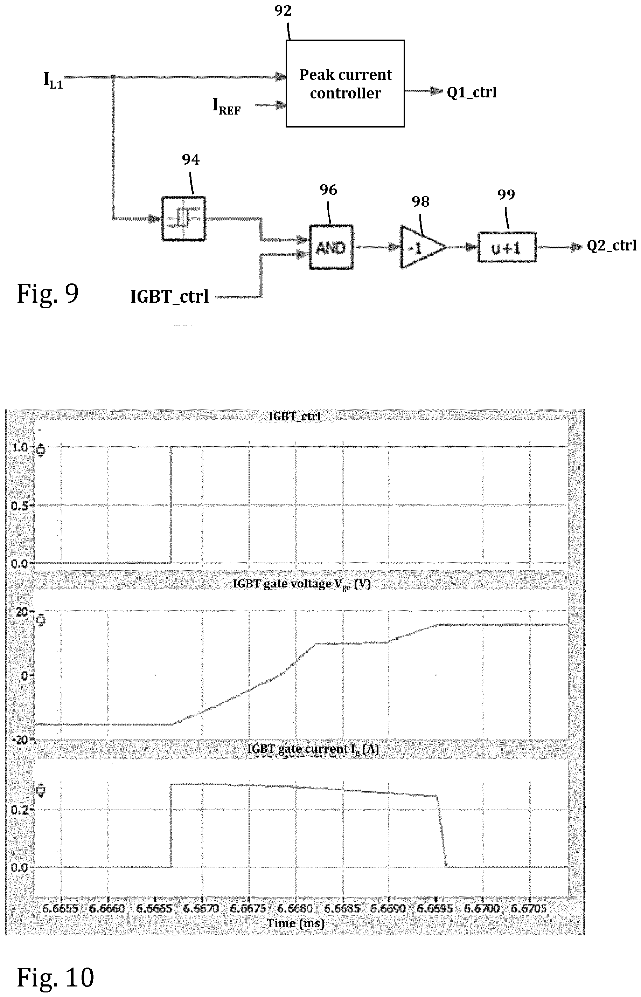

Fig. 9 shows a simplified block diagram illustrating an exemplary control logic for controlling the main switch Q1 and the auxiliary switch Q2 of the turn-on converter circuit 22. Similar control logic can be used for controlling the main switch Q3 and the auxiliary switch Q4 of the turn-off converter circuit 24. In the example, a peak current controller 92 is provided to control the main switch Q1 and thereby the peak inductor current $I_{L1}$ in the inductor L1, as illustrated in the upper control branch in Fig. 9. The peak current controller 92 outputs a PWM control signal Q1_ctrl that turns on and off the main switch Q1 at a predetermined switching frequency. The switching frequency of Q1 can be relatively low, for example in the range of tens of kHz. The switching frequency may be set by the inductance value of the inductor L1 and the desired current ripple level. Basically, when the main switch Q1 turned on, the voltage drop across the inductor L1 is positive; therefore, inductor current $I_{L1}$ will increase accordingly. When the main switch Q1 is switched off, the inductor current slope becomes negative. The peak current controller 92 receives the sensed inductor current $I_{L1}$ and a reference current $I_{REF}$. The reference current $I_{REF}$ may be a constant value, or it may be provided by an outer voltage control loop that controls the gate voltage $V_{ge}$, for example. The control signal Q1_ctrl may be pulse width modulated based on the sensed inductor current $I_{L1}$ and a reference current $I_{REF}$ so that the inductance current $I_{L1}$ will not exceed the reference current $I_{REF}$.

In the example, the auxiliary switch Q2 is primarily controlled on and off based the IGBT control signal IGBT_ctrl, as illustrated in the lower control branch in Fig. 9. An inverting block 98 and an offset block 99 may be provided to invert the IGBT control signal IGBT_ctrl to form the auxiliary control signal Q2_ctrl. For example, when the IGBT is to be turned off and the IGBT_ctrl is at a low state (0), the output of a logical AND operator block 96 is always at a high state (1) (regardless of the other input of the AND block), the auxiliary control signal Q2 is at a high state (1), and the auxiliary switch Q2 is turned on. In the turn-off stage of the IGBT, the inductor current of the inductor L1 is shunted to the ground through the auxiliar switch Q2 and the main switch Q1 is able to increase the inductor current $I_{L1}$, as there is a positive voltage drop across the inductor L1.

On the other hand, when the IGBT is to be turned on and the IGBT_ctrl is at a high state (1), the output of a logical AND operator block 96 is at a high state (1) (assuming that the other input of the AND block 96 is at a high state also), the auxiliary control signal Q2 is at a low state (1), and the auxiliary switch Q2 is turned off. In the turn-on stage of the IGBT, the energy stored in the inductor L1 provides the turn-on current to the gate of the IGBT. In other words, the inductor current $I_{L1}$ is routed to the gate of the IGBT through the diode D2. However, in the steady state of the turn-on stage, when the auxiliary switch is turned off, there is not a positive voltage drop across the inductor L1, as the gate voltage $V_{ge}$ is at the rail. Therefore, inductor current $I_{L1}$ cannot be increased, when the main switch Q1 turned on. In embodiments, the auxiliary switch Q2 may be temporarily turned on for short periods of time during the turn-on stage of the IGBT to keep the current in the inductor L1 flowing. In the exemplary embodiment shown in Fig. 9, a two-point hysteresis block 94 is used to provide the second input to the AND block 96 based on the sensed inductor current $I_{L1}$. The two-point hysteresis may be implemented as in Table 2, i.e., it may have the low threshold level $I_{bst,low}$ and the high threshold level $I_{bst,high}$. The output of the hysteresis block 94 is at a high state (1), when the inductor current $I_{L1}$ is sufficiently high the auxiliary switch Q2 is normally off, it the inductor current $I_{L1}$ is sufficiently high. During turn-on stage of the IGBT, when IGBT_ctrl is at a high state (1), also the output of the AND block 96 is at a high state (1) and the inverted control signal is at a low state (0), and the auxiliary switch Q2 is turned off. When the inductor current $I_{L1}$ drops below the low threshold level $I_{bst,low}$, the output of the hysteresis block 94 changes to a low state (0), the output of the AND block 96 changes to a low state (0), the inverter control signal Q2_ctrl changes to a high state (1), and the auxiliary switch Q2 is turned on to boost the inductor current. When the boosting operation has raised the inductor current $I_{L1}$ above the high threshold level $I_{bst,high}$, the output of the hysteresis block 94 changes back to a low state (0) causing the auxiliary switch Q2 to be turned off again.

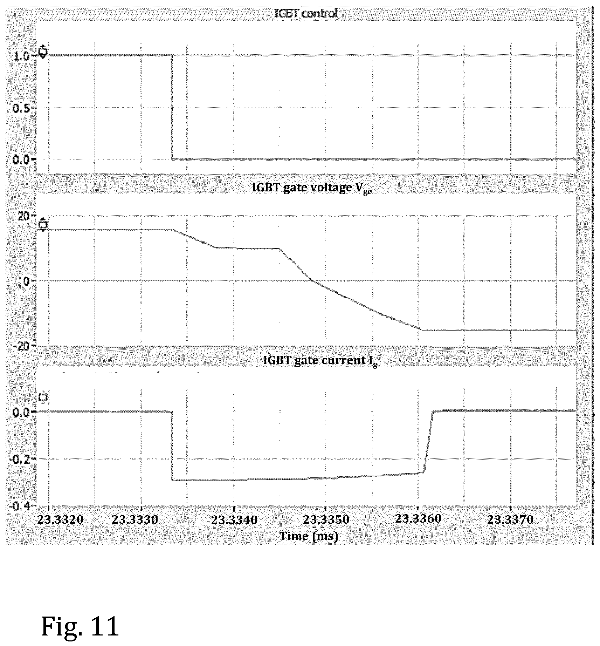

Example waveforms of a gate driver according to an embodiment of the invention are discussed with reference to Figs. 10, 11 and 12. In the example, the nominal gate current $I_g$ = 300 mA, $V_{cc}$ = +15 V, $V_{ee}$ = -15 V, L1 = L2 = 1.25 mH, $I_{bst,low}$ = 100 mA, $I_{bst,high}$ = 200 mA, and the switching frequency of the peak current control is about 50 kHz. Figures 10 and 11 show the IGBT control signal IGBT_ctrl, the IGBT gate voltage $V_{ge}$ and the gate current $I_g$ during turn-on and turn-off voltage transitions, respectively. During the turn-on transition, the gate voltage swings from the negative supply voltage to the positive supply voltage. During the turn-off transition, the gate voltage swings from the positive supply voltage to the negative supply voltage. It can be seen that the gate current $I_g$ is rather constant during the voltage transition, even though the control loops in the system are much slower than the transition time. By increasing the inductors' inductance, the current droop could be made even smaller.

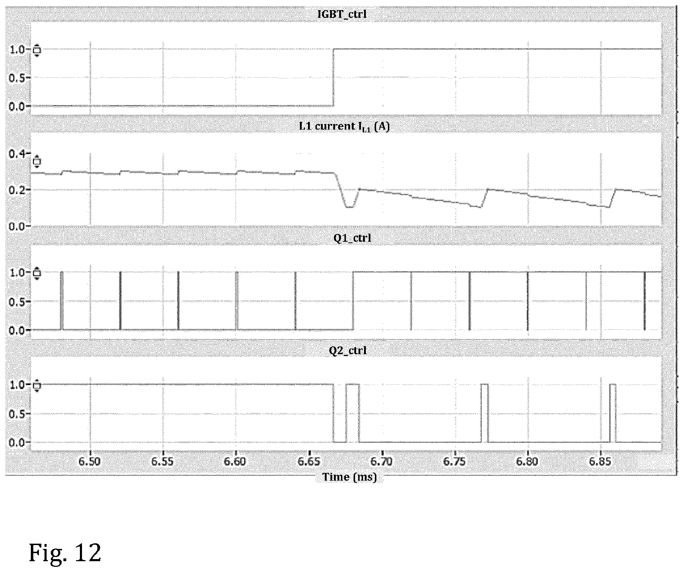

In Fig. 12, the inductor current $I_{L1}$ and switch control signals Q1_ctrl and Q2_ctrl for the turn-on event are shown. Before the turn-on of the IGBT (IGBT_ctrl = 0), the auxiliary switch Q2 is conducting (Q2_ctrl =1), and no current flows to the IGBT gate G. Instead, the peak current controller 92 keeps the inductor current $I_{L1}$ at the desired level, about 300 mA. When the IGBT control signal IGBT_ctrl changes state to 1, and the IGBT is controlled on, the auxiliary switch Q2 is switched off (Q2_ctrl =0) and current flows to the IGBT gate G. After that, the boosting operation starts which can be seen as periodic on-pulses in the control signal Q2_ctrl, which keeps the inductor current $I_{L1}$ at predefined level, in this case between 100 mA and 200 mA. The behaviour of the turn-off circuit 24 is identical and is not shown here.

A down-side of constant current gate drivers may be that the switching delay time of the IGBT may become large as the gate voltage $V_{ge}$ is slowly ramped from the supply voltage level to the threshold level of the IGBT.

According to a second aspect of the invention, to mitigate this problem, paralleling two or more "1-stage" current source gate drivers according to the first aspect of the invention to form a multistage source current driver. The driver outputs of parallel connected current source gate drivers, called gate driver stages herein, are connected together to drive a single semiconductor switching device. The parallel gate driver stages can be selectively enabled and disabled to boost the gate current $I_g$ during the voltage transition. When two or more parallel-connected gate driver stages are enabled at the same time, their turn-on currents or turn-off currents are summed, and thereby the resulting turn-on current or turn-off current is doubled or multiplied corresponding to the number of the enabled gate driver stages. Paralleling can be used to e.g. decrease the delay time before the transistor's switching event happens. The higher (boosted) gate current will decrease the time needed to charge the gate capacitor of the semiconductor power switching device (e.g., IGBT) and raise the gate voltage to the threshold voltage of the semiconductor power switching device. This novel feature can be utilized to simplify the hard parallel connection of semiconductor power switching devices. The "pre-boosting" multistage current gate driver can be used to equalize the internal switching delays and switching speeds of the semiconductor power switching devices in a switching apparatus, such as a power converter, an inverter, or a rectifier. It is possible to avoid any preselection of power semiconductors for the application based on their switching characteristics as the switching characteristics can be equalized by the multistage gate driver. Even power semiconductors from different vendors could be parallel connected.

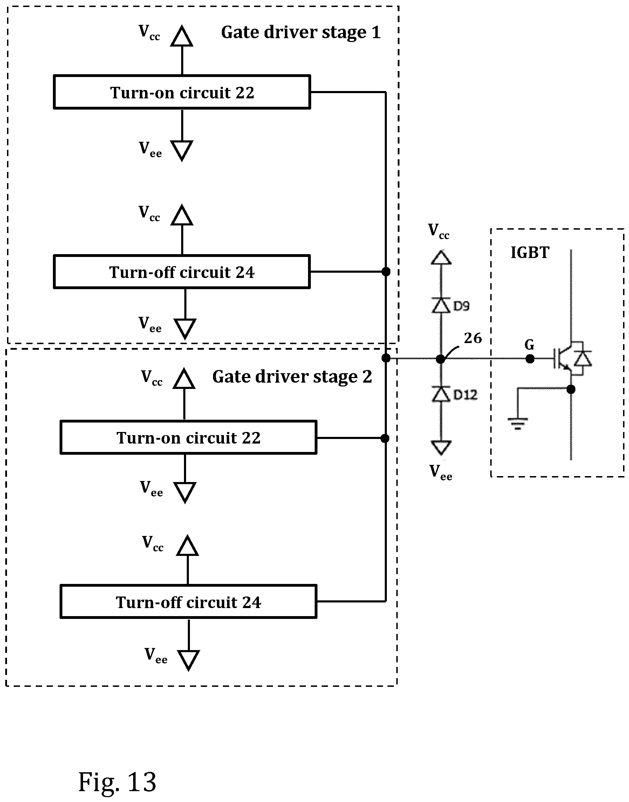

Fig. 13 is a simplified block diagram illustrating a 2-stage gate driver where two current source gate drivers according to the first aspect of the invention, i.e., the gate driver stages 1 and 2, are connected in parallel. The driver outputs 26 of parallel connected gate driver stages are connected together and to the gate G of the same IGBT.

In embodiments, the parallel driver stages can be selectively enabled and disabled using the auxiliary switches of the driver stages.

In embodiments, the selective enabling and disabling of the parallel driver stages is time-based. For example, for a certain period of time after start of a turn-on event (e.g., IGBT_ctrl changes to 1), the turn-on circuits 22 of both/all gate driver stages 1 and 2 are enabled (the auxiliary switches Q2 of both/all turn-on circuits are turned off), and then all but one of the turn-on circuits 22 are disabled (their auxiliary switches Q2 are turned on). The last turn-on circuit 22 may continue operation in the turn-on state of the IGBT as described with reference to the first aspect of the invention. Similarly, for a certain period of time after start of a turn-off event, the turn-off circuits 24 of both/all gate driver stages 1 and 2 are enabled (the auxiliary switches Q4 of both/all turn-off circuits 24 are turned off), and then all but one of the turn-off circuits 24 are disabled (their auxiliary switches Q4 are turned on). The last turn-off circuit 24 may continue operation in the turn-off state of the IGBT as described with reference to the first aspect of the invention. Further, it is possible that after the IGBT transition, i.e. a predefined longer period of time, the additional boosting stages (or some of them) are again enabled to rapidly raise/lower the gate voltage to the supply voltage rail, to reduce the switching losses further.

In embodiments, the selective turning on and turning off of the parallel driver stages is based on the level of the gate voltage. For example, if during turn-on of the semiconductor power switching device (e.g., IGBT), the gate voltage is below a positive boost threshold, turn-on circuits 22 of both/all gate driver stages 1 and 2 are enabled. After the gate voltage exceeds the positive boost threshold, the turn-on circuits 22 of all but one of the gate driver stages 1 and 2 are disabled. The turn-on circuit 22 of the last enabled gate driver stage may continue operation in the turn-on state of the IGBT as described with reference to the first aspect of the invention. In a turn-off, the gate voltage is first at high voltage, and the turn-off current can be boosted until the gate voltage has decreased to a turn-off boost threshold (e.g., about 10V) above the threshold voltage (e.g., around 6...7 V) where the IGBT starts transitioning. So, if during turn-off of the semiconductor power switching device (e.g., IGBT), the negative-going gate voltage is higher than the turn-off boost threshold, turn-off circuits 24 of both/all gate driver stages 1 and 2 are enabled. After the negative-going gate voltage becomes lower than the turn-off boost threshold, the turn-off circuits 24 of all but one of the gate driver stages 1 and 2 are disabled.

In embodiments, the turn-on circuit of the last enabled gate driver stage 24 may continue operation in the turn-off state of the IGBT as described with reference to the first aspect of the invention.

In embodiments, after the IGBT transition, i.e. after the gate voltage exceeds a predefined positive higher level in the IGBT turn-on, one or more of the turn-on circuits of the disabled gate driver stages may be again enabled to boost the final part of the IGBT turn-on, i.e., to rapidly raise the gate voltage to the positive supply voltage rail, to reduce the switching losses further. Similarly, after the IGBT turn-off, i.e. after the negative-going gate voltage is lower than a predefined lower voltage level in turn-off, one or more of the turn-off circuits of the disabled gate driver stages may be again enabled to boost the final part of the IGBT turn-off, i.e., to rapidly lower the gate voltage to the negative supply voltage rail, to reduce the switching losses further. Moreover, a rapid decrease in the gate voltage after the switching makes it possible to use a shorter dead time or a shorter commutation delay, because the likelihood of a parasitic turn-on is reduced with a lowering gate voltage. In embodiments, the predefined positive higher level is a voltage high enough to turn-on the IGBT or higher. In embodiments, the predefined turn-off lower threshold is a voltage low enough to turn-off the IGBT or lower.

An aspect of the invention is switching apparatus, particularly a power converter, an inverter, or a rectifier, having two or more semiconductor power switching devices. Each of the two or more semiconductor power switching devices is driven by a dedicated switch-mode current source gate driver according to the first aspect of the invention or by a multistage gate driver apparatus according to the second aspect of the invention.

The gate driver control, such as the controller 20, controlling the gate driver in accordance embodiments of the invention may be implemented by various means. For example, these techniques may be implemented in hardware (one or more devices), firmware (one or more devices), software (one or more modules), or combinations thereof. For a firmware or software, implementation can be through modules (e.g., procedures, functions, and so on) that perform the functions described herein. The software codes may be stored in any suitable, processor/computer-readable data storage medium(s) or memory unit(s) and executed by one or more processors/computers. The data storage medium or the memory unit may be implemented within the processor/computer or external to the processor/computer, in which case it can be communicatively coupled to the processor/computer via various means as is known in the art.

The description and the related drawings are only intended to illustrate the principles of the present invention by means of examples. Various alternative embodiments, variations and changes are obvious to a person skilled in the art on the basis of this description. The present invention is not intended to be limited to the examples described herein but the invention may vary within the scope and spirit of the appended claims.

**Claims**

1. A switch-mode current source gate driver comprising:

   a dc voltage bus having a positive rail and a negative rail couplable to a dc power supply,
   a driver output couplable to drive a gate of a power semiconductor switching device,
   a turn-on d-dc converter circuit having a first series inductor acting as a current source for producing a turn-on current to the gate of the power semiconductor switching device, the turn-on dc-dc converter circuit being configured to keep a turn-on current of a desired level flowing continuously in the first series inductor regardless of whether the driven power semiconductor switching device is in a turn-on stage or a turn-off stage, the turn-on dc-dc converter circuit having a first mode of operation in which the continuous turn-on current is caused to flow to the gate of the power semiconductor switching device in the turn-on stage, and a second mode of operation in which the continuous turn-on current is shunted to the power supply in the turn-off stage,
   a turn-off dc-dc converter circuit having a second series inductor acting as a current source for producing a turn-off current to the gate of the power semi-conductor switching device, the turn-off dc-dc converter circuit being configured to keep a turn-off current of a desired level flowing continuously in the second inductance regardless of whether the driven power semiconductor switching device is in the turn-on stage or the turn-off stage, the turn-off dc-dc converter circuit having a first mode of operation in which the continuous turn-off current is caused to flow to the gate of the power semiconductor switching device in the turn-off stage, and a second mode of operation in which the continuous turn-off current is shunted to the power supply in the turn-on stage, and
   a controller configured to control the modes of operation of the turn-on dc-dc converter circuit and the turn-off dc-dc converter circuit, wherein the controller is configured to control the turn-on dc-dc converter circuit into the first mode and the turn-off dc-dc converter circuit into the second mode to drive the power semiconductor switching device into the turn-on stage, and wherein the controller is configured to control the turn-on dc-dc converter circuit into the second mode and the turn-off dc-dc converter circuit into the first mode to drive the power semiconductor switching device into the turn-off stage.

2. The switch-mode current source gate driver as claimed in claim 1, wherein the controller comprises a first current-mode controller to adjust the turn-on current and a second current-mode controller to adjust the turn-off current, the current-mode controllers preferably being peak current controllers or average current controllers.

3. The switch-mode current source gate driver as claimed in claim 1 or 2, wherein

   the turn-on dc-dc converter circuit is configured to temporarily shunt the turn-on current to the power supply during the turn-on stage of the semiconductor power switching device to boost the continuous turn-on current flowing in the first series inductor, and wherein
   the turn-off dc-dc converter circuit is configured to temporarily shunt the turn-off current to the power supply during the turn-off stage of the semiconductor power switching device to boost the continuous turn-off current flowing in the second series inductor.

4. The switch-mode current source gate driver as claimed in claim 3, wherein the controller is configured to sense the turn-on current and the turn-off current and selectively boost the currents so that the turn-on current and the turn-off current have at least a predetermined levels or are within predetermined ranges.

5. The switch-mode current source gate driver as claimed in any preceding claim, wherein

   the turn-on dc-dc converter circuit comprises a first controllable main switch to control the level of the continuous turn-on current in the first series inductor, and a first controllable auxiliary switch to either cause the continuous turn-on current from the first series inductor to the gate of the semiconductor power switch or to shunt the continuous turn-on current from the first series inductor to the power supply, and wherein

the turn-off dc-dc converter circuit comprises a first controllable main switch to control the level of the continuous turn-off current in the second series inductor, and a second controllable auxiliary switch to either cause the continuous turn-off current from the second series inductor to the gate of the semiconductor power switch or to shunt the continuous turn-off current from the second series inductor to the power supply.

6. The switch-mode current source gate driver as claimed in claim 5, wherein

the first controlled main switch is operationally connected between the positive rail and a first terminal of the first series inductor and the first controlled auxiliary switch is operationally connected between a second terminal of the first series inductor and the negative rail, and wherein
the second controlled main switch is operationally connected between the negative rail and a first terminal of the second series inductor and the second controlled auxiliary switch is operationally connected between a second terminal of the second series inductor and the positive rail.

7. The switch-mode current source gate driver as claimed in any preceding claim, wherein

the turn-on dc-dc converter circuit comprises a first freewheeling semiconductor device operationally connected between the first terminal of the first series inductor and the negative rail, and a second blocking semiconductor device operationally connected between the second terminal of the first series inductor and the driver output, and wherein
the turn-off dc-dc converter circuit comprises a third freewheeling semiconductor device operationally connected between the first terminal of the second series inductor and the positive rail, and a fourth blocking semiconductor device operationally connected between the second terminal of the second series inductor and the driver output.

8. The switch-mode current source gate driver as claimed in any preceding claim, comprising a first clamping diode operationally connected between the driver output and the positive rail, and a second clamping diode operationally connected between the driver output and the negative rail.

9. A gate driver apparatus comprising two or more switch-mode current source drivers according to any one of claims 1-8, wherein the two or more switch-mode current source drivers are connected in parallel to drive one semiconductor power switching device, wherein the parallel gate driver stages can be selectively enabled and disabled to boost a gate current during a gate voltage transition.

10. The gate driver apparatus as claimed in claim 9, wherein the parallel gate driver stages are selectively enabled and disabled by selectively turning on and off the auxiliary switches of the gate driver stages.

11. The gate driver apparatus as claimed in claim 9 or 10, wherein the selective enabling and disabling of the parallel gate driver stages is time-based.

12. The gate driver apparatus as claimed in claim 9 or 10, wherein the selective enabling and disabling of the parallel gate driver stages is based on the level of the gate voltage.

13. The gate driver apparatus as claimed in claim 9, 10 or 11, wherein

the turn-on dc-dc converter circuits of all gate driver stages are enabled after start of a turn-on event,
the turn-on dc-dc converter circuits of all but one of the gate driver stages are disabled after certain period or periods of time,
the turn-off dc-dc converter circuits of all gate driver stages are enabled after start of a turn-off event, and
the turn-off dc-dc converter circuits of all but one of the gate driver stages are disabled after certain period or periods of time.

14. The gate driver apparatus as claimed in claim 9, 10 or 12, wherein the turn-on dc-dc converter circuits of all gate driver stages are enabled, when the gate voltage is below a positive boost threshold during a turn-on event,

the turn-on dc-dc converter circuits of all but one of the gate driver stages are disabled, when the gate voltage exceeds the positive boost threshold during the turn-on event,
the turn-off dc-dc converter circuits of all gate driver stages are enabled, when the gate voltage is higher than the turn-off boost threshold during a turn-off event,

the turn-off dc-dc converter circuits of all but one of the gate driver stages are disabled, when the gate voltage is lower than the turn-off boost threshold during the turn-off event.

**15.** The gate driver apparatus as claimed in claim 13 or 14, wherein

the turn-on dc-dc converter circuit of one or more disabled gate driver stages enabled again to boost the final part of the IGBT turn-on after the gate voltage exceeds a predefined positive higher level, and
the turn-off dc-dc converter circuit of one or more disabled gate driver stages enabled again to boost the final part of the IGBT turn-off after the gate voltage is lower than a predefined lower turn-off threshold level.16. A switching apparatus, particularly a power converter, an inverter, or a rectifier, comprising
two or more semiconductor power switching devices,
the switch-mode current source gate driver as claimed in any one of claims 1-8 or the gate driver apparatus as claimed in any one of claims 9-15 for each of the two or more semiconductor power switching devices.

Fig. 1

Fig. 2

Fig. 3

Fig. 4

Fig. 5

Fig. 6

Fig. 7

Fig. 8

92

Peak current
controller → Q1_ctrl

$I_{L1}$

$I_{REF}$ →

94

96        98        99

AND → -1 → u+1 → Q2_ctrl

Fig. 9

IGBT_ctrl

IGBT_ctrl

IGBT gate voltage $V_{ge}$ (V)

IGBT gate current $I_g$ (A)

6.6655  6.6660  6.6665  6.6670  6.6675  6.6680  6.6685  6.6690  6.6695  6.6700  6.6705
Time (ms)

Fig. 10

Fig. 11

Fig. 12

Fig. 13

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/308098 A1 (SCHIMEL PAUL [US]) 28 September 2023 (2023-09-28) | 1-7,16 | INV. H03K17/0412 |
| Y | * see passages mentionned in the written opinion.; figures 1, 2, 3 * | 8-15 | H02M1/00 H02M1/08 H02M3/158 H03K17/16 |
| Y | US 7 459 945 B2 (TOSHIBA KK [JP]) 2 December 2008 (2008-12-02) | 8 | |
| A | * figure 1 * | 1-7,16 | |
| Y | US 2023/318438 A1 (NORA PAOLO [IT] ET AL) 5 October 2023 (2023-10-05) | 9-15 | |
| A | * see passages mentionned in the written opinion.; figure 11 * | 1-8,16 | |
| A | US 12 103 406 B2 (DELPHI TECH IP LTD [BB]) 1 October 2024 (2024-10-01) * figure 6 * | 1-16 | |
| | | | **TECHNICAL FIELDS SEARCHED (IPC)** |
| | | | H03K H02M |

The present search report has been drawn up for all claims

| Place of search | Date of completion of the search | Examiner |
|---|---|---|
| The Hague | 4 June 2025 | Fermentel, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

**Application Number**

**EP 24 20 8412**

The Search Division considers that the present European patent application does not comply with the requirements of unity of invention and relates to several inventions or groups of inventions, namely:

```
      1. claims: 1-8, 16

            Switch-mode current source gate driver comprising a turn-on
            dc-dc converter and a turn-off dc-dc converter
                              ---

      2. claims: 9-15

            Gate driver apparatus comprising two or more switch-mode
            current source drivers
                              ---
```

## ANNEX TO THE EUROPEAN SEARCH REPORT
## ON EUROPEAN PATENT APPLICATION NO.

EP 24 20 8412

This annex lists the patent family members relating to the patent documents cited in the above-mentioned European search report.
The members are as contained in the European Patent Office EDP file on
The European Patent Office is in no way liable for these particulars which are merely given for the purpose of information.

04-06-2025

| Patent document cited in search report | | Publication date | Patent family member(s) | | Publication date |
|---|---|---|---|---|---|
| US 2023308098 | A1 | 28-09-2023 | CN | 118104134 A | 28-05-2024 |
| | | | DE | 112023001536 T5 | 20-02-2025 |
| | | | US | 2023308098 A1 | 28-09-2023 |
| | | | WO | 2023183551 A1 | 28-09-2023 |
| US 7459945 | B2 | 02-12-2008 | JP | 3840241 B2 | 01-11-2006 |
| | | | JP | 2006054954 A | 23-02-2006 |
| | | | US | 2006034114 A1 | 16-02-2006 |
| US 2023318438 | A1 | 05-10-2023 | CN | 118805325 A | 18-10-2024 |
| | | | DE | 112023001226 T5 | 09-01-2025 |
| | | | US | 2023318438 A1 | 05-10-2023 |
| | | | WO | 2023172928 A1 | 14-09-2023 |
| US 12103406 | B2 | 01-10-2024 | CN | 119768913 A | 04-04-2025 |
| | | | CN | 119769029 A | 04-04-2025 |
| | | | CN | 119790595 A | 08-04-2025 |
| | | | CN | 119790596 A | 08-04-2025 |
| | | | CN | 119817034 A | 11-04-2025 |
| | | | CN | 119836743 A | 15-04-2025 |
| | | | CN | 119895566 A | 25-04-2025 |
| | | | CN | 119895716 A | 25-04-2025 |
| | | | CN | 119895717 A | 25-04-2025 |
| | | | CN | 119895718 A | 25-04-2025 |
| | | | CN | 119895719 A | 25-04-2025 |
| | | | CN | 119895720 A | 25-04-2025 |
| | | | CN | 119895721 A | 25-04-2025 |
| | | | CN | 119908065 A | 29-04-2025 |
| | | | CN | 119908071 A | 29-04-2025 |
| | | | CN | 119908072 A | 29-04-2025 |
| | | | CN | 119948744 A | 06-05-2025 |
| | | | CN | 119948749 A | 06-05-2025 |
| | | | CN | 119999061 A | 13-05-2025 |
| | | | CN | 119999093 A | 13-05-2025 |
| | | | US | 11718190 B1 | 08-08-2023 |
| | | | US | 2024100954 A1 | 28-03-2024 |
| | | | US | 2024100963 A1 | 28-03-2024 |
| | | | US | 2024100966 A1 | 28-03-2024 |
| | | | US | 2024100968 A1 | 28-03-2024 |
| | | | US | 2024100979 A1 | 28-03-2024 |
| | | | US | 2024103045 A1 | 28-03-2024 |
| | | | US | 2024103559 A1 | 28-03-2024 |
| | | | US | 2024105533 A1 | 28-03-2024 |
| | | | US | 2024105534 A1 | 28-03-2024 |
| | | | US | 2024105547 A1 | 28-03-2024 |
| | | | US | 2024105552 A1 | 28-03-2024 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 24 20 8412

This annex lists the patent family members relating to the patent documents cited in the above-mentioned European search report.
The members are as contained in the European Patent Office EDP file on
The European Patent Office is in no way liable for these particulars which are merely given for the purpose of information.

04-06-2025

| Patent document cited in search report | Publication date | Patent family member(s) | Publication date |
|---|---|---|---|
| | | US 2024105553 A1 | 28-03-2024 |
| | | US 2024105684 A1 | 28-03-2024 |
| | | US 2024106319 A1 | 28-03-2024 |
| | | US 2024106323 A1 | 28-03-2024 |
| | | US 2024106337 A1 | 28-03-2024 |
| | | US 2024106338 A1 | 28-03-2024 |
| | | US 2024106339 A1 | 28-03-2024 |
| | | US 2024106346 A1 | 28-03-2024 |
| | | US 2024106347 A1 | 28-03-2024 |
| | | US 2024106350 A1 | 28-03-2024 |
| | | US 2024106352 A1 | 28-03-2024 |
| | | US 2024106353 A1 | 28-03-2024 |
| | | US 2024106354 A1 | 28-03-2024 |
| | | US 2024106368 A1 | 28-03-2024 |
| | | US 2024106369 A1 | 28-03-2024 |
| | | US 2024106370 A1 | 28-03-2024 |
| | | US 2024106371 A1 | 28-03-2024 |
| | | US 2024106372 A1 | 28-03-2024 |
| | | US 2024106373 A1 | 28-03-2024 |
| | | US 2024106374 A1 | 28-03-2024 |
| | | US 2024106375 A1 | 28-03-2024 |
| | | US 2024106376 A1 | 28-03-2024 |
| | | US 2024106378 A1 | 28-03-2024 |
| | | US 2024106379 A1 | 28-03-2024 |
| | | US 2024106381 A1 | 28-03-2024 |
| | | US 2024107675 A1 | 28-03-2024 |
| | | US 2024107718 A1 | 28-03-2024 |
| | | US 2024107719 A1 | 28-03-2024 |
| | | US 2024107720 A1 | 28-03-2024 |
| | | US 2024107721 A1 | 28-03-2024 |
| | | US 2024113081 A1 | 04-04-2024 |
| | | US 2024399895 A1 | 05-12-2024 |
| | | US 2025089224 A1 | 13-03-2025 |
| | | US 2025126762 A1 | 17-04-2025 |
| | | US 2025133708 A1 | 24-04-2025 |

------------------------------------------------------------------------

EPO FORM P0459

For more details about this annex : see Official Journal of the European Patent Office, No. 12/82

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WOLF-GANG FRANK et al.** Current Source Gate Drivers Boost the Turn-On Performance of IGBT. *Infineon Technologies AG*, November 2018
- **LU SHU et al.** Active Current Source IGBT Gate Drive with Closed-Loop di/dt and dv/dt Control. *IEEE Transactions On Power Electronics*, May 2017, vol. 32 (5)
- **J. DIAZ**. A New Lossless Power Mosfet Driver Based on Simple DC/DC Converters. IEEE, 1995
- **AYATO SAGEHASHI et al.** *9th International Conference on Power Electronics-ECCE Asia*, June 2015